# FASCICULE DE BREVET EUROPEEN

(11) **EP 4 028 272 B1**
(45) Date de publication et mention de la délivrance du brevet: **13.11.2024**
(21) Numéro de dépôt: 20768038.0
(22) Date de dépôt: 09.09.2020
(51) Int. Cl.: B60K 1/00, H05K 7/20, B60K 11/02, B60K 11/04

(54) **MODULE DE PUISSANCE ÉLECTRIQUE**
ELEKTRISCHES LEISTUNGSMODUL
ELECTRIC POWER MODULE

(30) Priorité: 10.09.2019 FR 1909973
(43) Date de publication de la demande: 20.07.2022
(73) Titulaire: ALSTOM Holdings, 93400 Saint-Ouen-sur-Seine (FR)
(72) Inventeur: NICOLAU, Sébastien, 65100 LOUBAJAC (FR); VALLE, Gilles, 65430 SOUES (FR)
(74) Mandataire: Lavoix
(86) Numéro de dépôt international: PCT/EP2020/075144
(87) Numéro de publication internationale: WO 2021/048167

(56) Documents cités:
- EP-A1- 0 771 138
- EP-A1- 3 217 776
- EP-A1- 3 426 013
- DE-U1- 202015 103 197

## Description

La présente invention concerne un coffre de traction destiné à être disposé en toiture d'un véhicule ferroviaire, le coffre comportant un module de puissance électrique, du type comportant un dispositif de conversion de courant électrique et un dispositif de refroidissement dudit dispositif de conversion.

Un tel module de puissance électrique avec système de refroidissement est notamment décrit dans le document EP2291067.

Un coffre de traction destiné à être disposé en toiture d'un véhicule ferroviaire, le coffre comportant au moins un panneau supérieur de couverture et un module de puissance électrique, est connu du document EP 3 426 013 A1.

Les dispositifs de conversion de courant électrique comprennent classiquement des éléments semi-conducteurs, qui font partie des éléments émetteurs de chaleur nécessitant un refroidissement. Ces éléments semi-conducteurs, ainsi que les dispositifs électroniques de commande correspondants, nécessitent de fréquentes interventions d'entretien et/ou de remplacement.

Dans les modules de puissance actuels, ces opérations d'entretien présentent des contraintes importantes. En particulier, il est souvent nécessaire de faire intervenir plusieurs opérateurs en raison du poids des éléments à démonter. En outre, les systèmes de refroidissement font souvent intervenir des interfaces thermiques à base de produits fluides de type graisse, qui génèrent également des contraintes en cas de démontage.

La présente invention a pour but d'optimiser une architecture du module de puissance afin de remédier à ces inconvénients.

A cet effet, l'invention a pour objet un un coffre de traction comme défini dans la revendication 1.

Suivant d'autres aspects avantageux de l'invention, le module de puissance électrique comporte l'une ou plusieurs des caractéristiques suivantes, prises isolément ou suivant toutes les combinaisons techniquement possibles :
- le dispositif de conversion de courant électrique comporte au moins un bloc de conversion, le ou chaque bloc de conversion comprenant une barre de connexion et deux unités de conversion, les éléments semi-conducteurs de chacune desdites deux unités de conversion étant munis de moyens amovibles de connexion avec ladite barre de connexion, les supports des deux unités de conversion étant disposés de part et d'autre de la barre de connexion ;
- les éléments semi-conducteurs de chaque unité de conversion sont des transistors bipolaires à grille isolée ;
- au moins un premier échangeur thermique est assemblé à une interface thermique solide, de sorte que dans la position assemblée dudit premier échangeur thermique avec une unité de conversion, ladite interface thermique assure un transfert thermique entre la pluralité d'éléments semi-conducteurs de ladite unité de conversion et ledit premier échangeur thermique ;
- le dispositif de refroidissement comprend : un circuit fermé de fluide caloporteur ; et un deuxième échangeur thermique apte à transférer de la chaleur dudit fluide caloporteur vers un flux d'air généré par un déplacement du véhicule ferroviaire ; chacun des premiers échangeurs thermiques et le deuxième échangeur thermique étant disposés sur ledit circuit fermé ;
- chaque unité de conversion présente une masse totale inférieure à 30 kg, de préférence inférieure à 20 kg.

L'invention se rapporte en outre à un véhicule ferroviaire comportant une chaîne de traction comprenant un moteur électrique et un coffre de traction tel que décrit ci-dessus, ledit coffre de traction étant situé en toiture dudit véhicule.

L'invention se rapporte en outre à un procédé d'entretien d'un véhicule ferroviaire tel que décrit ci-dessus, ledit procédé comprenant les étapes suivantes : déplacement du ou d'un panneau supérieur de couverture en position ouverte ; actionnement des moyens d'assemblage amovible, de sorte à dissocier le support d'une unité de conversion d'avec le premier échangeur thermique correspondant ; et extraction de ladite unité de conversion du coffre de traction.

L'invention sera mieux comprise à la lecture de la description qui va suivre, donnée uniquement à titre d'exemple non limitatif et faite en se référant aux dessins sur lesquels :
- la figure 1 est une vue schématique partielle, de face, en coupe, d'un véhicule ferroviaire comprenant un module de puissance électrique selon un mode de réalisation de l'invention ; et
- la figure 2 est une vue de détail du module de puissance électrique de la figure 1 selon un mode particulier de réalisation de l'invention.

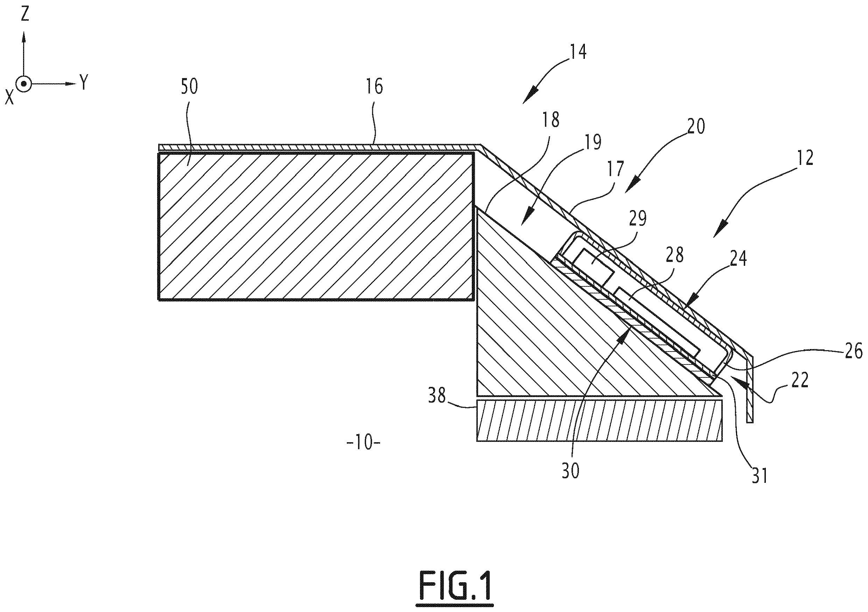

La figure 1 représente un véhicule ferroviaire 10 comprenant un module de puissance 12, ou convertisseur de puissance électrique. Le véhicule ferroviaire 10 est par exemple un véhicule moteur d'une rame de transport de passagers ou de fret. Le véhicule ferroviaire 10 comporte notamment un moteur électrique (non représenté) d'une chaîne de traction, alimenté en énergie électrique par le module de puissance 12.

Le véhicule ferroviaire 10 comporte notamment un coffre de traction 14, situé en toiture dudit véhicule et visible sur la figure 1.

On considère une base orthonormée (X, Y, Z), la direction Z représentant la verticale, la direction X correspondant à une direction longitudinale de déplacement du véhicule ferroviaire 10 et la direction Y correspondant à une direction transversale horizontale.

Une surface extérieure du coffre de traction 14 est définie par un panneau central 16, sensiblement disposé dans un plan (X, Y) et par des panneaux latéraux 17, situés de part et d'autre du panneau central 16. Les panneaux latéraux 17 sont sensiblement symétriques l'un de l'autre par rapport à un plan (X, Z) médian du véhicule ferroviaire 10. Un seul des panneaux latéraux 17 est visible sur la figure 1.

Chaque panneau latéral 17 est incliné, une extrémité en contact avec le panneau central 16 étant plus haute qu'une extrémité opposée. Il en résulte une forme convexe classique du coffre de traction 14. Un panneau latéral est incliné d'un angle compris entre 20° et 60° par rapport à l'horizontale.

Par ailleurs, le coffre de traction 14 comprend une structure interne comportant au moins un plan incliné 18, sensiblement parallèle à un panneau latéral 17 et disposé sous ledit panneau latéral. Un espace situé entre ledit panneau latéral 17 et ledit plan incliné 18 forme un compartiment interne 19 du coffre de traction 14.

De préférence, chaque panneau latéral 17 est mobile entre une position fermée, telle que représentée sur la figure 1, et une position ouverte. Ladite position ouverte permet à un opérateur d'accéder au compartiment interne 19.

Le module de puissance 12 comporte un dispositif 20 de conversion de courant électrique, et un dispositif 22 de refroidissement dudit dispositif de conversion 20.

Le dispositif de conversion 20 comporte notamment une pluralité d'unités de conversion 24. Comme visible sur la figure 1, chaque unité de conversion 24 comprend notamment un support 26, une pluralité d'éléments semi-conducteurs 28 et une carte électronique 29 de commande desdits éléments semi-conducteurs 28. Les éléments semi-conducteurs 28 et la carte électronique 29 sont fixés au support 26.

Les éléments semi-conducteurs 28 sont de type transistor. Préférentiellement, les éléments semi-conducteurs 28 sont des transistors bipolaires à grille isolée (IGBT). Les IGBT ont notamment une fonction de commutateurs dans chaque unité de conversion 24.

Les unités de conversion 24 sont disposées dans le compartiment interne 19 fermé par l'un ou l'autre des panneaux latéraux 17. Préférentiellement, les unités de conversion 24 sont disposées en vis-à-vis d'un panneau latéral 17.

D'une manière générale, chaque unité de conversion 24 comprend préférentiellement des composants du dispositif de conversion 20 qui nécessitent des opérations fréquentes d'entretien et/ou de remplacement.

Le dispositif 22 de refroidissement comporte une pluralité de premiers échangeurs thermiques 30. Dans une position assemblée d'un premier échangeur thermique 30 avec une unité de conversion 24, les éléments semi-conducteurs, en particulier les IGBT 28, sont en contact thermique avec ledit premier échangeur 30 de sorte à céder de la chaleur audit premier échangeur.

Chaque premier échangeur thermique 30 est par exemple disposé sur le plan incliné 18. Selon un mode de réalisation, une interface thermique 31 est disposée sur au moins l'un des premiers échangeurs thermiques 30, de sorte à être interposée entre ledit premier échangeur 30 et les IGBT 28 dans la position assemblée. De préférence, l'interface thermique 31 est formée d'un matériau solide et du type interface sèche.

Comme il sera détaillé par la suite, le module 12 comprend des moyens 44 d'assemblage amovible du support 26 de chaque unité de conversion 24 avec le premier échangeur thermique 30 correspondant. Ainsi, chaque unité de conversion 24 est apte à être dissociée dudit premier échangeur 30 et du reste du module 12.

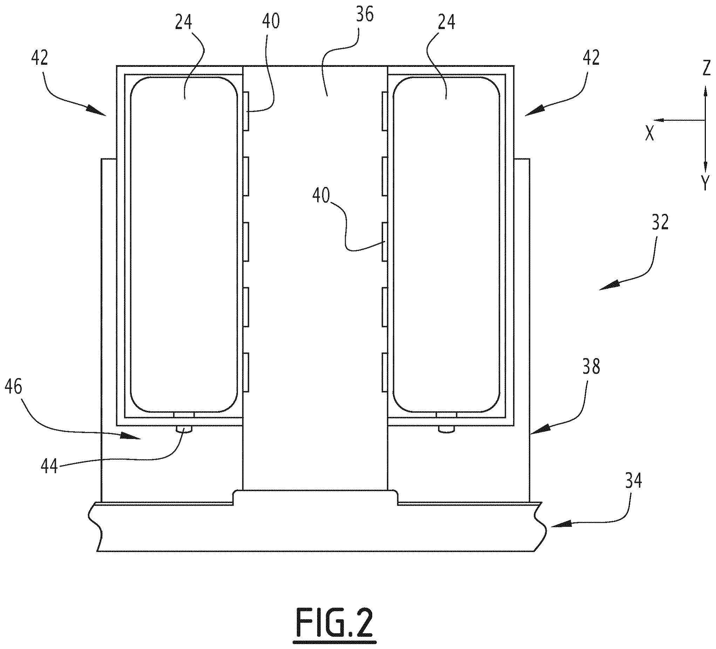

Selon un mode de réalisation, le dispositif 20 de conversion de courant électrique comporte au moins un bloc de conversion 32, tel que représenté à la figure 2. Le bloc de conversion 32 comporte notamment deux unités de conversion 24 telles que décrites ci-dessus, ainsi qu'un socle 34, une barre de connexion 36 et une capacité filtre 38.

La barre de connexion 36, ou busbar, a la forme d'une plaque sensiblement plane. Le bloc de conversion 32 est configuré de sorte que la barre de connexion 36 et les IGBT de chacune des deux unités de conversion 24 soient disposés de manière sensiblement coplanaire. La barre de connexion 36 est par exemple disposée entre les deux unités de conversion 24 selon la direction X. Les IGBT de chacune des deux unités de conversion 24 sont munis de moyens amovibles de connexion avec la barre de connexion 36, tels que des plots de connexion 40.

Le socle 34 comprend deux réceptacles 42, chacun desdits réceptacles étant destiné à s'assembler de manière amovible avec l'une des deux unités de conversion 24. Plus précisément, chaque unité de conversion 24 comprend des moyens 44 d'assemblage amovible avec l'un des réceptacles 42 du socle 34. Les moyens d'assemblage amovible 44 sont par exemple de type vis

Par ailleurs, une masse totale de chaque unité de conversion 24 est de préférence limitée à une quinzaine ou une vingtaine de kilogrammes environ, de manière à ce qu'une unité de conversion puisse être manipulée par un seul opérateur et sans outillage spécifique.

De préférence, le bloc de conversion 32 est configuré de sorte que la capacité filtre 38 soit disposée sous la barre de connexion 36 et les deux unités de conversion 24. Plus préférentiellement, le socle 34 est configuré de sorte qu'un espace 46 soit ménagé entre les réceptacles 42 et la capacité filtre 38, le plan incliné 18 et les premiers échangeurs thermiques 30 étant reçus dans ledit espace 46.

Dans la position assemblée telle que représentées aux figures 1 et 2, chaque unité de conversion 24 du bloc de conversion 32 est assemblée à l'un des réceptacles 42 ; et les IGBT 28 de chacune desdites unités de conversion 24 sont en contact thermique avec le premier échangeur thermique 30 correspondant, via l'interface thermique 31.

Le dispositif de refroidissement 22 comporte en outre un deuxième échangeur thermique 50, apte à échanger de la chaleur avec un flux d'air généré par un déplacement du véhicule ferroviaire. Le deuxième échangeur 50 est par exemple disposé en partie centrale du coffre de traction 14, sous le panneau central 16.

Le deuxième échangeur thermique 50 est préférentiellement un radiateur à ailettes. Plus préférentiellement, le deuxième échangeur thermique 50 est dimensionné de sorte qu'une circulation du véhicule ferroviaire 10 suffise à évacuer suffisamment de chaleur, sans nécessiter de ventilateurs.

Le dispositif de refroidissement 22 comporte en outre un circuit fermé (non représenté) de fluide caloporteur, reliant la pluralité de premiers échangeurs thermiques 30 au deuxième échangeur thermique 50. Ledit fluide caloporteur dudit circuit fermé est apte à transférer de la chaleur de chacun des premiers échangeurs thermiques 30 vers le deuxième échangeur thermique 50.

De préférence, le fluide caloporteur est diphasique et les premiers échangeurs thermiques 30 comprennent des évaporateurs capillaires, comme décrit notamment dans le document EP2291067. Chaque évaporateur capillaire est traversé par le fluide caloporteur diphasique.

Le fluide caloporteur diphasique est par exemple choisi parmi le méthanol et l'acétone.

Un fonctionnement du module de puissance 12 va à présent être décrit.

Le moteur électrique de la chaîne de traction du véhicule ferroviaire 10 décrit ci-dessus est mis en fonctionnement, pour le déplacement dudit véhicule ferroviaire. Les unités de conversion 24 du module de puissance 12 sont également mises en fonctionnement. Les IGBT 28 de chaque unité de conversion 24 dégagent donc de la chaleur qui diffuse par conduction à travers l'interface thermique 31 jusqu'au premier échangeur thermique 30 correspondant. Le fluide caloporteur du dispositif de refroidissement 22 transfère ladite chaleur au deuxième échangeur thermique 50. Au niveau dudit deuxième échangeur, ladite chaleur est cédée à un flux d'air généré par le déplacement du véhicule ferroviaire 10.

En cas d'entretien nécessaire d'une unité de conversion 24, un opérateur déplace le panneau 17 correspondant de la position fermée à la position ouverte, puis déconnecte les plots de connexion 40 et actionne les moyens 44 d'assemblage amovible de l'unité de conversion 24 concernée, de sorte à dissocier ladite unité de conversion 24 de son réceptacle 42.

L'unité de conversion 24 concernée est ainsi aisément extraite du compartiment 19 du coffre de traction 14. Cette extraction est facilitée par le poids limité d'une unité de conversion, qui peut être manipulée par un seul opérateur.

En outre, la nature solide de l'interface thermique 31 facilite la dissociation des IGBT 28 d'avec leur dispositif de refroidissement, le transfert thermique n'étant pas assuré par un matériau visqueux de type huile ou graisse.

En outre, le démontage de l'unité de conversion 24 ne nécessite aucune intervention sur le circuit de fluide caloporteur du dispositif de refroidissement 22.

Après des interventions au niveau des IGBT 28 et/ou de la carte électronique 29, l'unité de conversion 24 est réassemblée au reste du module 12 par un procédé inverse.

La configuration du module 12 permet ainsi d'intervenir facilement et rapidement au niveau des composants nécessitant le plus d'entretien, tels que les transistors IBGT et les cartes électroniques. L'entretien peut ainsi être réalisé par un seul opérateur, sans contraintes particulières.

## Revendications

1. Coffre de traction (14) destiné à être disposé en toiture d'un véhicule ferroviaire (10), ledit coffre comportant : au moins un panneau supérieur (17) de couverture, le ou chaque panneau supérieur étant mobile entre une position ouverte et une position fermée ; et un module (12) de puissance électrique comportant :
- un dispositif (20) de conversion de courant électrique ; et
- un dispositif (22) de refroidissement dudit dispositif de conversion ;
ledit dispositif de conversion comportant une pluralité d'unités de conversion (24), chaque unité de conversion comprenant : un support (26), une pluralité d'éléments semi-conducteurs (28) et une carte électronique (29) de commande desdits éléments semi-conducteurs, les éléments semi-conducteurs et la carte électronique étant fixés au support ;
ledit dispositif de refroidissement comprenant une pluralité de premiers échangeurs thermiques (30) tels que, dans une position assemblée d'un premier échangeur thermique avec une unité de conversion, la pluralité d'éléments semi-conducteurs (28) est en contact thermique avec ledit premier échangeur de sorte à céder de la chaleur audit premier échangeur ;
le module comprenant des moyens (44) d'assemblage amovible du support (26) de chaque unité de conversion avec le premier échangeur correspondant, ledit support étant apte à être dissocié dudit premier échangeur et du reste du module de puissance électrique ;
le coffre de traction étant **caractérisé en ce que** :
- le ou chaque panneau supérieur est destiné, en position fermée, à être incliné d'un angle compris entre 20° et 60° par rapport à l'horizontale ; et
- le coffre de traction comprend une structure interne comportant au moins un plan incliné (18), disposé sous l'au moins un panneau supérieur (17) et sensiblement parallèle audit panneau supérieur en position fermée ; un espace situé entre ledit panneau supérieur et ledit plan incliné (18) formant un compartiment interne (19) du coffre de traction ;
chaque unité de conversion (24) étant située dans ledit compartiment interne, en vis-à-vis dudit ou de l'un desdits panneaux supérieurs (17) de couverture.

2. Coffre de traction selon la revendication 1, dans lequel le dispositif (20) de conversion de courant électrique du module (12) comporte au moins un bloc de conversion (32), le ou chaque bloc de conversion comprenant une barre de connexion (36) et deux unités de conversion (24), les éléments semi-conducteurs (28) de chacune desdites deux unités de conversion étant munis de moyens amovibles (40) de connexion avec ladite barre de connexion, les supports (26) des deux unités de conversion étant disposés de part et d'autre de la barre de connexion.

3. Coffre de traction selon la revendication 2, dans lequel : le ou chaque bloc de conversion comprend en outre un socle (34) et une capacité filtre (38) ; le socle comprend deux réceptacles (42), chacun desdits réceptacles étant destiné à s'assembler de manière amovible avec l'une des deux unités de conversion ; et le socle (34) est configuré de sorte qu'un espace (46) soit ménagé entre les réceptacles (42) et la capacité filtre (38), le plan incliné (18) et les premiers échangeurs thermiques (30) étant reçus dans ledit espace.

4. Coffre de traction selon l'une des revendications précédentes, dans lequel les éléments semi-conducteurs (28) de chaque unité de conversion (24) du module (12) sont des transistors bipolaires à grille isolée.

5. Coffre de traction selon l'une des revendications précédentes, dans lequel au moins l'un des premiers échangeurs thermiques (30) est assemblé à une interface thermique (31) solide, de sorte que dans la position assemblée dudit premier échangeur thermique avec une unité de conversion (24), ladite interface thermique assure un transfert thermique entre la pluralité d'éléments semi-conducteurs (28) de ladite unité de conversion et ledit premier échangeur thermique.

6. Coffre de traction selon l'une des revendications précédentes, dans lequel le dispositif de refroidissement comprend : un circuit fermé de fluide caloporteur ; et un deuxième échangeur thermique (50) apte à transférer de la chaleur dudit fluide caloporteur vers un flux d'air généré par un déplacement du véhicule ferroviaire (10) ; chacun des premiers échangeurs thermiques (30) et le deuxième échangeur thermique étant disposés sur ledit circuit fermé.

7. Coffre de traction selon l'une des revendications précédentes, dans lequel au moins l'un des premiers échangeurs thermiques (30) est disposé sur le plan incliné (18).

8. Véhicule ferroviaire (10) comportant une chaîne de traction comprenant un moteur électrique et un coffre de traction (14) selon l'une des revendications précédentes, ledit coffre de traction étant situé en toiture dudit véhicule, de sorte qu'en position fermée, le ou chaque panneau supérieur du coffre de traction est incliné d'un angle compris entre 20° et 60° par rapport à l'horizontale.

9. Procédé d'entretien d'un véhicule ferroviaire selon la revendication 8, ledit procédé comprenant les étapes suivantes :
- déplacement du ou d'un panneau supérieur (17) de couverture en position ouverte ;
- actionnement des moyens (44) d'assemblage amovible, de sorte à dissocier le support (26) d'une unité de conversion (24) d'avec le premier échangeur thermique (30) correspondant ; et
- extraction de ladite unité de conversion du coffre de traction (14).

## Patentansprüche

1. Zugsteuerungskasten (14), der bestimmt ist, auf dem Dach eines Schienenfahrzeugs (10) angeordnet zu sein, wobei der Kasten aufweist: mindestens eine obere Abdeckplatte (17), wobei die oder jede obere Platte zwischen einer geöffneten Position und einer geschlossenen Position beweglich ist; und ein elektrisches Leistungsmodul (12), das aufweist:
- eine Vorrichtung (20) zur Umwandlung von elektrischem Strom; und
- eine Vorrichtung (22) zum Kühlen der Umwandlungsvorrichtung;
wobei die Umwandlungsvorrichtung eine Vielzahl von Umwandlungseinheiten (24) aufweist, wobei jede Umwandlungseinheit umfasst: einen Halter (26), eine Vielzahl von Halbleiterelementen (28) und eine elektronische Karte (29) zur Steuerung der Halbleiterelemente, wobei die Halbleiterelemente und die elektronische Karte am Halter befestigt sind;
wobei die Kühlvorrichtung eine Vielzahl erster Wärmetauscher (30) umfasst, so dass in einer zusammengebauten Position eines ersten Wärmetauschers mit einer Umwandlungseinheit die Vielzahl von Halbleiterelementen (28) in thermischem Kontakt mit dem ersten Wärmetauscher steht, so dass Wärme an den ersten Wärmetauscher abgegeben wird;
wobei das Modul Mittel (44) zum lösbaren Zusammenbau des Halters (26) jeder Umwandlungseinheit mit dem entsprechenden ersten Wärmetauscher umfasst, wobei der Halter von dem ersten Wärmetauscher und dem Rest des elektrischen Leistungsmoduls trennbar ist;
wobei der Zugsteuerungskasten **dadurch gekennzeichnet ist, dass**:
- die oder jede obere Platte dazu bestimmt ist, in geschlossener Position in einem Winkel zwischen 20° und 60° in Bezug auf die Horizontale geneigt zu sein; und
- der Zugsteuerungskasten eine innere Struktur umfasst, die mindestens eine geneigte Ebene (18) aufweist, die unter mindestens einer oberen Platte (17) angeordnet und etwa parallel zu der oberen Platte in geschlossener Position ist; wobei ein Raum zwischen der oberen Platte und der geneigten Ebene (18) ein inneres Fach (19) des Zugsteuerungskastens bildet;
wobei sich jede Umwandlungseinheit (24) in dem inneren Fach gegenüber der oder einer der oberen Abdeckplatten (17) befindet.

2. Zugsteuerungskasten nach Anspruch 1, wobei die Vorrichtung (20) zur Umwandlung von elektrischem Strom des Moduls (12) mindestens einen Umwandlungsblock (32) umfasst, wobei der oder jeder Umwandlungsblock eine Verbindungsschiene (36) und zwei Umwandlungseinheiten (24) umfasst, wobei die Halbleiterelemente (28) jeder der beiden Umwandlungseinheiten mit lösbaren Mitteln (40) zur Verbindung mit der Verbindungsschiene versehen sind, wobei die Halter (26) der beiden Umwandlungseinheiten auf beiden Seiten der Verbindungsschiene angeordnet sind.

3. Zugsteuerungskasten nach Anspruch 2, wobei: der oder jeder Umwandlungsblock ferner einen Sockel (34) und eine Filterkapazität (38) umfasst; der Sockel zwei Behältnisse (42) umfasst, wobei jedes der Behältnisse bestimmt ist, lösbar mit der einen der beiden Umwandlungseinheiten zusammenbaubar zu sein; und der Sockel (34) derart ausgelegt ist, dass ein Raum (46) zwischen den Behältnissen (42) und der Filterkapazität (38) ausgebildet wird, wobei die geneigte Ebene (18) und die ersten Wärmetauscher (30) in dem Raum aufgenommen sind.

4. Zugsteuerungskasten nach einem der vorhergehenden Ansprüche, wobei die Halbleiterelemente (28) jeder Umwandlungseinheit (24) des Moduls (12) bipolare Transistoren mit isoliertem Gate sind.

5. Zugsteuerungskasten nach einem der vorhergehenden Ansprüche, wobei mindestens einer der ersten Wärmetauscher (30) mit einer festen thermischen Schnittstelle (31) zusammengebaut ist, so dass in der zusammengebauten Position des ersten Wärmetauschers mit einer Umwandlungseinheit (24) die thermische Schnittstelle eine Wärmeübertragung zwischen der Vielzahl von Halbleiterelementen (28) der Umwandlungseinheit und dem ersten Wärmetauscher gewährleistet.

6. Zugsteuerungskasten nach einem der vorhergehenden Ansprüche, wobei die Kühlvorrichtung umfasst: einen geschlossenen Kreislauf eines Wärmeträgerfluids; und einen zweiten Wärmetauscher (50), der geeignet ist, Wärme von dem Wärmeträgerfluid auf einen Luftstrom zu übertragen, der durch eine Bewegung des Schienenfahrzeugs (10) erzeugt wird; wobei jeder von den ersten Wärmetauschern (30) und der zweite Wärmetauscher in dem geschlossenen Kreislauf angeordnet ist.

7. Zugsteuerungskasten nach einem der vorhergehenden Ansprüche, wobei mindestens einer der ersten Wärmetauscher (30) auf der geneigten Ebene (18) angeordnet ist.

8. Schienenfahrzeug (10) mit einem Antriebsstrang, der einen Elektromotor und einen Zugsteuerungskasten (14) nach einem der vorhergehenden Ansprüche umfasst, wobei sich der Zugsteuerungskasten auf dem Dach des Fahrzeugs befindet, so dass in geschlossener Position die oder jede obere Platte des Zugsteuerungskastens in einem Winkel zwischen 20° und 60° im Verhältnis zur Horizontalen geneigt ist.

9. Verfahren zur Wartung eines Schienenfahrzeugs nach Anspruch 8, wobei das Verfahren die folgenden Schritte umfasst:
- Verlagern der oder einer oberen Abdeckplatte (17) in geöffnete Position;
- Betätigen der Mittel (44) zur lösbaren Verbindung, so dass der Halter (26) einer Umwandlungseinheit (24) von dem entsprechenden ersten Wärmetauscher (30) gelöst wird; und
- Herausziehen der Umwandlungseinheit aus dem Zugsteuerungskasten (14).

## Claims

1. A traction box (14) intended to be arranged on the roof of a railway vehicle (10), said box including: at least one upper cover panel (17), the or each upper cover panel being movable between an open position and a closed position; and an electric power module (12) including:
- an electric current conversion device (20) and
- a device (22) for cooling the conversion device;
said conversion device including a plurality of conversion units (24), each conversion unit comprising: a support (26), a plurality of semiconductor elements (28) and an electronic board (29) for controlling said semiconductor elements, the semiconductor elements and the electronic board being fastened to the support;
said cooling device comprising a plurality of first heat exchangers (30) such that, in an assembled position of a first heat exchanger with a conversion unit, the plurality of semiconductor elements (28) is in thermal contact with said first heat exchanger so as to yield heat to said first heat exchanger;
the module comprising means (44) for removably assembling the support (26) of each conversion unit with the corresponding first exchanger, said support being apt to be dissociated from said first exchanger and from the rest of the electric power module;
the traction box being **characterized in that**:
- the or each upper panel is intended, in the closed position, to be inclined at an angle comprised between 20° and 60° with respect to the horizontal; and
- the traction box comprises an internal structure including at least one inclined plane (18), arranged under at least one upper panel (17) and substantially parallel to said upper panel in the closed position; a space located between said upper panel and said inclined plane (18) forming an internal compartment (19) of the traction box
each conversion unit (24) being located in said inner compartment, facing said or one of said upper cover panels (17).

2. - The traction box according to claim 1, wherein the electric current conversion device (20) of the module (12) includes at least one conversion block (32), the or each conversion block comprising a connection bar (36) and two conversion units (24), the semiconductor elements (28) of each of said two conversion units being provided with removable means (40) for connection with said connection bar, the supports (26) of the two conversion units being arranged on either side of the connection bar.

3. - The traction box according to claim 2, wherein: the or each conversion block further comprises a base (34) and a filter capacity (38); the base comprising two receptacles (42), each of said receptacles being intended for being removably assembled with one of the two conversion units; and the base (34) being configured such that a space (46) is provided between the receptacles (42) and the filter capacity (38), the inclined plane (18) and the first heat exchangers (30) being received in said space.

4. - The traction box according to one of the preceding claims, wherein the semiconductor elements (28) of each conversion unit (24) of the module (12) are insulated-gate bipolar transistors.

5. - The traction box according to one of the preceding claims, wherein at least one of the first heat exchangers (30) is assembled onto a solid thermal interface (31), such that in the assembled position of said first heat exchanger with a conversion unit (24), said thermal interface provides heat transfer between the plurality of semiconductor elements (28) of said conversion unit and said first heat exchanger.

6. - The traction box according to one of the preceding claims, wherein the cooling device comprises: a closed circuit of heat transfer fluid; and a second heat exchanger (50) apt to transfer heat from said heat transfer fluid to an air flow generated by a movement of the railway vehicle (10); each of the first heat exchangers (30) and the second heat exchanger being arranged on said closed circuit.

7. - The traction box according to one of the preceding claims, wherein at least one of the first heat exchangers (30) is arranged on the inclined plane (18).

8. - A railway vehicle (10) including a traction chain comprising an electric motor and a traction box (14) according to one of the preceding claims, said traction box being located on the roof of said vehicle, so that in the closed position, the or each upper panel of the traction box is inclined at an angle comprised between 20° and 60° with respect to the horizontal.

9. - A servicing method for a railway vehicle according to claim 8, the method comprising the following steps:
- moving the or an upper cover panel (17) to the open position;
- actuation of the removable means (44) of assembly so as to dissociate the support (26) of a conversion unit (24) from the corresponding first heat exchanger (30); and
- extraction of said conversion unit from the traction box (14).
